(19) Europäisches Patentamt
European Patent Office
Office européen des brevets

(11) **EP 2 746 851 A2**

(12) **DEMANDE DE BREVET EUROPEEN**

(43) Date de publication:
**25.06.2014 Bulletin 2014/26**

(51) Int Cl.:
***G03F 7/20*** (2006.01)

(21) Numéro de dépôt: **13195869.6**

(22) Date de dépôt: **05.12.2013**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **18.12.2012 FR 1262228**

(71) Demandeurs:
• **COMMISSARIAT A L'ENERGIE ATOMIQUE ET AUX
ENERGIES ALTERNATIVES
75015 Paris (FR)**

• **Aselta Nanographics
38000 Grenoble (FR)**

(72) Inventeur: **Belledent, Jérôme
38240 Meylan (FR)**

(74) Mandataire: **Tanguy, Yannick et al
Cabinet Orès
36, rue de Saint-Pétersbourg
75008 Paris (FR)**

(54) **Simulation des effets du bruit de grenaille sur un procédé de lithographie par faisceau de particules et notamment de lithographie électronique**

(57) Méthode de simulation des effets du bruit de grenaille sur un procédé de lithographie par faisceau de particules, et notamment de lithographie électronique, le procédé comportant le dépôt de particules sur la surface d'un échantillon suivant un motif prédéterminé au moyen d'un faisceau desdites particules, ledit motif étant subdivisé en pixels et une dose nominale de particules étant associée à chaque dit pixel, caractérisée en ce qu'elle comprend le calcul d'une mappe $\sigma_d$ d'écart type de la dose normalisée effectivement déposée sur chaque dit pixel, ladite mappe d'écart type étant calculée à partir d'une mappe $\mathbf{M}_0$ de ladite dose nominale associée à chaque pixel et d'une fonction d'étalement du point PSF caractérisant ledit procédé ; ladite méthode étant mise en oeuvre par ordinateur.

Produit programme d'ordinateur et ordinateur programmé pour la mise en oeuvre d'une telle méthode.

Procédé de lithographie par faisceau de particule, et notamment de lithographie électronique, comportant une opération préalable de simulation des effets du bruit de grenaille par une telle méthode.

*Fig. 2*

EP 2 746 851 A2

**Description**

L'invention porte sur une méthode de simulation informatique des effets du bruit de grenaille sur un procédé de lithographie par faisceau de particules. La méthode s'applique en particulier à la lithographie électronique, mais aussi, plus généralement, à tout procédé de lithographie utilisant des faisceaux de particules (y compris des photons) susceptibles d'être affectés par le bruit de grenaille (« *shot noise* » en anglais) : lithographie par rayons X, par faisceau laser, par faisceau d'ions, etc. Il convient de rappeler que le bruit de grenaille est dû à la nature discrète du faisceau ; il est donc d'autant plus important à prendre en considération que la dose utilisée correspond à un faible nombre de particules.

A cause du bruit de grenaille, les structures définies par lithographie présentent des bords de forme irrégulière dont la position ne coïncide pas exactement avec celle qui serait attendue sur la base d'une simulation déterministe du procédé. Cela impose une limite inférieure à la plus petite dimension (« dimension critique », ou « CD » de l'anglais « *critical dimension* ») pouvant être réalisée de manière fiable.

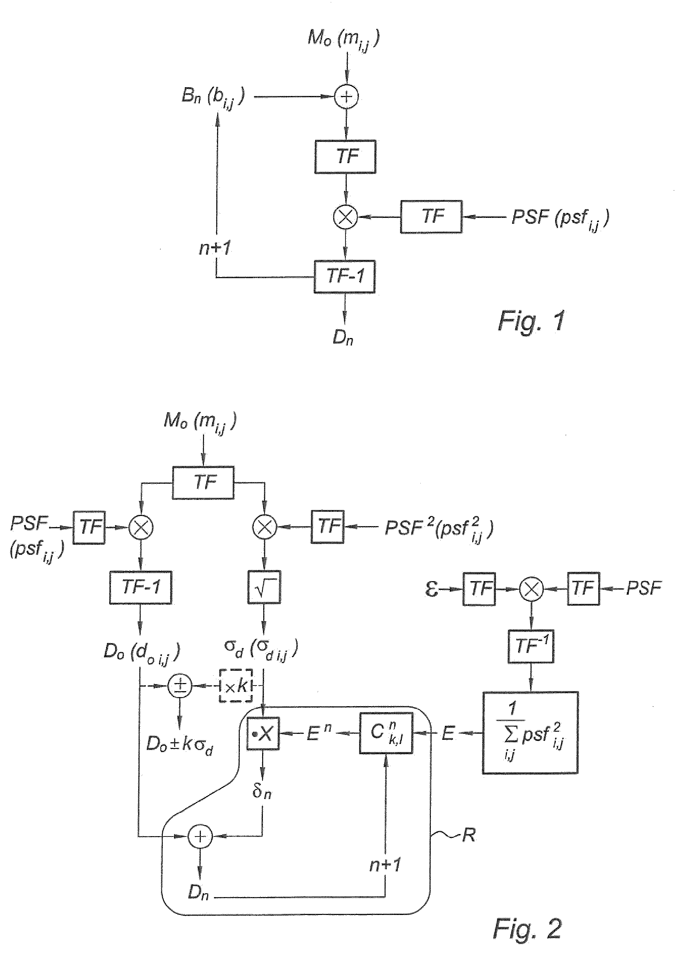

De manière conventionnelle, l'effet du bruit de grenaille est simulé à l'aide d'une méthode de type « Monte-Carlo », dont l'algorithme est illustré schématiquement sur la figure 1.

Le bruit est simulé par un générateur de nombres aléatoires et représenté par une matrice de variables aléatoires indépendantes $\mathbf{B_n}$ (éléments : $b_{i,j}$ suivant une loi de poisson) qui est additionnée à un motif pixélisé à réaliser par lithographie, représenté à son tour sous la forme d'une matrice $\mathbf{M_0}$ dont les éléments sont désignés par $m_{0i,j}$. Ensuite, le motif bruité est convolué avec une fonction d'étalement du point PSF (« *point spread function* » en anglais) - elle aussi représentée par une matrice $\mathbf{PSF}$, dont les éléments sont désignés pas $psf_{ij}$ - qui dépend des effets de dispersion du faisceau, mais également des propriétés de la résine de lithographie exposée par ledit faisceau et de son processus de développement, et qui caractérise donc le procédé. Concrètement, et d'une manière conventionnelle, la convolution $\mathbf{M_0} \otimes \mathbf{PSF}$ est calculée dans le domaine de Fourier, en multipliant la transformée de Fourier (TF) bidimensionnelle du motif bruitée par celle, préalablement stockée en mémoire, de la PSF, puis en effectuant la transformée de Fourier inverse (TF$^{-1}$) du résultat : $\mathbf{M_0} \otimes \mathbf{PSF} = \mathrm{TF}^{-1}[\mathrm{TF}(\mathbf{M_0})^* \mathrm{TF}(\mathbf{PSF})]$. On obtient ainsi une mappe $\mathbf{D_n}$ de dose simulée pour une réalisation possible (indice « n ») du processus aléatoire que constitue l'exposition de la résine en présence de bruit. En comparant la dose simulée $\mathbf{D_n}$ avec une valeur de seuil dépendant de la résine considérée, on obtient une représentation de l'exposition de la résine, et donc des structures qui seront réalisées après développement de la résine et gravure de l'échantillon sur lequel elle a été déposée. Des méthodes conventionnelles de traitement des images permettent ensuite d'extraire les contours desdites structures. Ce processus est répété plusieurs centaines de fois, avec à chaque fois une réalisation différente du bruit de grenaille, de manière à permettre une étude statistique du procédé.

Cette méthode est très lourde à mettre en oeuvre, car toutes les opérations doivent être répétées pour chaque réalisation du bruit, sans aucune réutilisation possible des calculs effectués. En particulier, la génération du bruit de grenaille nécessite d'associer à chaque pixel du motif une variable aléatoire. Le calcul d'une matrice de variables aléatoires, telle que $\mathbf{B_n}$, peut s'effectuer par décomposition de Cholesky de la matrice de corrélation, opération qui présente une complexité élevée tant du point de vue computationnel qu'en termes d'occupation de mémoire.

L'invention vise à procurer une méthode de simulation des effets du bruit de grenaille sur un procédé de lithographie par faisceau de particules plus simple et plus rapide que les méthodes connues de l'art antérieur.

Un objet de l'invention permettant d'atteindre ce but est une méthode de simulation des effets du bruit de grenaille sur un procédé de lithographie par faisceau de particules, le procédé comportant le dépôt de particules sur la surface d'un échantillon suivant un motif prédéterminé au moyen d'un faisceau desdites particules, ledit motif étant subdivisé en pixels et une dose nominale de particules étant associée à chaque dit pixel, caractérisée en ce qu'elle comprend le calcul d'une mappe $\sigma_d$ d'écart type de la dose normalisée effectivement déposée sur chaque dit pixel, ladite mappe d'écart type étant calculée à partir d'une mappe $\mathbf{M_0}$ de ladite dose nominale associée à chaque pixel et d'une fonction d'étalement du point $\mathbf{PSF}$ caractérisant ledit procédé ; ladite méthode étant mise en oeuvre par ordinateur.

En particulier, ladite mappe $\sigma_d$ d'écart type peut être calculée en appliquant la formule suivante :

$$\sigma_{d_{i_0,j_0}} = \sqrt{\sum_{i,j} \frac{psf_{i-i_0,j-j_0}^2}{\langle m_{i,j} \rangle} \left( \langle m_{i,j} \rangle > 0 \right)}$$

où $\sigma_{d_{i_0,j_0}}$ est l'élément de ladite mappe $\sigma_d$ correspondant au pixel de coordonnées $(i_0,j_0)$, $psf_{i,j}$ est la valeur de la fonction d'étalement du point $\mathbf{PSF}$ sur le pixel de coordonnées $(i,j)$ et $\langle m_{i,j} \rangle = m_{0i,j}$ est l'élément associé au pixel de coordonnées $(i,j)$ de ladite mappe $\mathbf{M_0}$ de la dose nominale exprimée en nombre de particules déposées, la somme étant effectuée sur tous les pixels pour lesquels $\langle m_{i,j} \rangle > 0$.

Dans le cas particulier où la dose nominale $\langle m_{i,j} \rangle$ associée à chaque pixel de coordonnées (*i,j*) prend une valeur choisie uniquement parmi 0 et un entier positif N (c'est-à-dire où une même dose nominale est affectée à tous les pixels du motif qui doivent être exposés, une dose nulle étant affectée aux autres pixels), ladite mappe $\sigma_d$ d'écart type peut être calculée en appliquant la formule suivante, qui dérive de la précédente mais présente une forme plus simple :

$$\sigma_{d_{i_0,j_0}} = \frac{1}{N} \sqrt{\sum_{i,j} psf^2_{i-i_0,j-j_0} \langle m_{i,j} \rangle}$$

La méthode peut comporter également une étape de détermination d'une plage de positionnement des bords d'au moins une structure réalisée sur ledit échantillon au moyen dudit procédé de lithographie, ladite étape comprenant :

• le calcul d'une première et d'une deuxième mappe de dose simulée, $\mathbf{D}_1$, $\mathbf{D}_2$ ;
• la comparaison de chaque dite mappe à une valeur seuil de dose pour définir au moins un motif de structure sur ledit échantillon ; et
• l'identification des bords de chaque dit motif de structure ;

ladite plage de positionnement étant comprise entre les bords ainsi identifiés ;
lesdites mappes de dose simulée étant calculées respectivement en ajoutant et en retranchant $k\sigma_d$, avec k>0, à une mappe de dose déterministe $\mathbf{D}_0$ obtenue par convolution de ladite mappe $\mathbf{M}_0$ de dose nominale associée et de ladite fonction d'étalement du point **PSF**.
En particulier, k peut être choisi égal à 3.
En variante ou en complément, la méthode peut comprendre également une étape de calcul d'une mappe de dose simulée **D** par addition d'une mappe de bruit de grenaille $\delta_n$ à une mappe de dose déterministe $\mathbf{D}_0$ (incluant les effets de la fonction d'étalement du point, supposée connue, mais pas ceux du bruit), dans laquelle :

- ladite mappe de dose déterministe $\mathbf{D}_0$ est obtenue par convolution de ladite mappe $\mathbf{M}_0$ de dose nominale et de ladite fonction d'étalement du point **PSF** ; et
- ladite mappe de bruit de grenaille $\delta_n$ est obtenue en multipliant élément par élément ladite mappe $\sigma_d$ d'écart type et une mappe d'erreur normalisé $\mathbf{E}_n$ présentant une longueur de corrélation donnée par ladite fonction d'étalement du point **PSF**.

En particulier, ladite mappe d'erreur normalisée peut être calculée par convolution de ladite fonction d'étalement du point avec une matrice $\varepsilon$ dont les éléments, associés à des pixels respectifs du motif, sont des variables aléatoires gaussiennes indépendantes d'écart type unitaire, et par normalisation du résultat en le divisant par un facteur $\sum_{i,j} psf^2_{i,j}$.

Afin d'effectuer une étude statistique, ladite étape de calcul d'une mappe de dose simulée peut être répétée une pluralité de fois en utilisant des mappes d'erreur normalisées $\mathbf{E}_n$ obtenues par permutation circulaire aléatoire des lignes et des colonnes d'une unique mappe d'erreur normalisée, dite mappe d'erreur mère **E ;** il est intéressant de noter que seuls le calcul des mappes d'erreur et leur addition à la mappe de dose déterministe doivent être itérés ; et ce calcul des mappes d'erreur est beaucoup plus simple que selon les méthodes de l'art antérieur.
Les mappes d'erreur normalisées En ainsi obtenues peuvent être utilisées comme variables d'entrée d'un modèle physico-chimique de la résine.
En variante, la méthode peut comporter également une étape de comparaison de chaque dite mappe de dose simulée à une valeur seuil de dose pour définir au moins un motif de structure respectif sur ledit échantillon, ainsi qu'une étape d'identification des bords de chaque dit motif de structure.
Avantageusement, le procédé peut comporter :

a) le calcul et le stockage dans une mémoire d'ordinateur de ladite mappe de dose déterministe $\mathbf{D}_0$, de ladite mappe $\sigma_d$ d'écart type de la dose normalisée et de ladite mappe d'erreur mère **E** ;
b) le calcul de ladite mappe de bruit de grenaille $\delta_n$ par permutation circulaire des lignes et des colonnes de ladite mappe d'erreur mère **E** et sa multiplication élément par élément avec ladite mappe $\sigma_d$ d'écart type de la dose normalisée ;
c) le calcul d'une mappe de dose simulée **D** par addition de ladite mappe de dose déterministe $\mathbf{D}_0$ et de ladite mappe de bruit de grenaille $\delta_n$ ;

lesdites étapes b) et c) étant répétées une pluralité de fois avec des permutations circulaires différentes de lignes et des colonnes de ladite mappe d'erreur mère **E**.

Comme expliqué plus haut, ledit procédé de lithographie par faisceau de particules peut être, en particulier, un procédé de lithographie électronique.

En particulier, ledit procédé de lithographie peut utiliser un adressage vectoriel du faisceau, la méthode comportant également une opération de subdivision conceptuelle dudit motif en pixels et de détermination d'une dose reçue par chaque dit pixel.

Un autre objet de l'invention est un produit programme d'ordinateur pour la mise en oeuvre d'une méthode selon l'une des revendications précédentes.

Encore un autre objet de l'invention est un ordinateur programmé pour la mise en oeuvre d'une telle méthode.

Encore un autre objet de l'invention est un procédé de lithographie par faisceau de particule comportant une opération préalable de simulation des effets du bruit de grenaille selon une telle méthode. Un tel procédé peut servir en particulier à la fabrication de composants électroniques ou optoélectroniques, de circuits intégrés, de dispositifs microélectromécaniques (MEMS) et/ou de masques de photolithographie.

D'autres caractéristiques, détails et avantages de l'invention ressortiront à la lecture de la description faite en référence aux dessins annexés donnés à titre d'exemple, dans lesquels :

- La figure 2 est un ordinogramme d'une méthode selon deux modes de réalisation de l'invention ;
- La figure 3 est la représentation d'un motif de lithographie à réaliser, utilisé pour illustrer la méthode de l'invention ;
- Les figures 4A - C, 5 et 6 justifient la validité du calcul de la mappe $\sigma_d$ d'écart type de la dose normalisée effectivement déposée sur l'échantillon en correspondance de chaque pixel du motif de la figure 3 ;
- La figure 7 illustre la fonction d'auto-corrélation de la dose effectivement déposée à un emplacement spécifique de l'échantillon ;
- La figure 8A est une mappe d'erreur obtenue conformément à l'invention et la figure 8B un graphique de sa fonction de corrélation, comparée à celle obtenue à partir d'un motif de lithographie affecté d'un bruit suivant une statistique de Poisson ;
- La figure 9 illustre le résultat technique de l'invention en comparant une plage de positionnement des bords d'une structure réalisée par lithographie électronique, déterminée par une méthode selon l'invention (9A) et selon l'art antérieur (9B).

L'invention sera décrite ci-après en référence à un procédé de lithographie électronique en « mode point » (« *raster image* » en anglais), c'est-à-dire utilisant un faisceau « ponctuel » d'électron balayant point par point un échantillon recouvert de résine lithographique (« *resist* ») suivant un motif pixélisé. Toutefois, comme cela a été évoqué plus haut, elle s'applique également à des procédés utilisant d'autres particules que les électrons. Elle s'applique également aux techniques de lithographie utilisant un adressage vectoriel, par exemple un faisceau présentant une forme prédéfinie (généralement rectangulaire) et de taille variable à chaque « coup » d'exposition. Dans ce cas, on subdivise (« rendering ») conceptuellement la zone d'écriture en pixels, on fait l'hypothèse d'une distribution uniforme de la dose à l'intérieur de chaque dite zone prédéfinie et on détermine la dose reçue par chaque pixel, ce qui permet de se ramener au cas de la lithographie en mode point.

Une représentation algorithmique d'un procédé selon l'invention est donnée par l'ordinogramme de la figure 2. Comme on peut le voir, ce procédé comprend deux parties principales, qui peuvent être mises en oeuvre dans un ordre quelconque ou en parallèle : le calcul d'une mappe (ou matrice) de dose déterministe $\mathbf{D}_0$ (éléments $d_{i,j}$) incluant les effets de la fonction d'étalement du point, supposée connue, mais pas ceux du bruit (branche de gauche de l'ordinogramme) ; et le calcul d'une mappe (ou matrice) de bruit de grenaille $\delta_n$ (branche de droite). La mappe de dose correspondant à une réalisation spécifique du bruit de grenaille, $\mathbf{D}_n$, est obtenue simplement en additionnant la mappe de dose déterministe et la mappe $\delta_n$ correspondant à ladite réalisation du bruit de grenaille : $\mathbf{D}_n=\mathbf{D}_0+\delta_n$. La branche de gauche de l'ordinogramme correspond à des opérations qui, pour un motif de lithographie $\mathbf{M}_0$ donné et pour un procédé de lithographie donné, caractérisé par une fonction d'étalement du point **PSF**, ne doivent être effectués qu'une seule fois ; il s'agit tout simplement de la convolution des matrices $\mathbf{M}_0$ et **PSF**. La mappe $\mathbf{D}_0$ ainsi calculée peut ensuite être stockée en mémoire. Comme cela sera expliqué ci-après, la branche de droite comprend à la fois des opérations qui peuvent être effectuées une seule fois, conduisant à des résultats intermédiaires destinés à être stockés en mémoire, et des opérations qui doivent être répétées pour chaque réalisation du bruit de grenaille. La mutualisation d'une grande partie des opérations et le stockage en mémoire de résultats intermédiaires permettent un gain significatif en termes de ressources de calcul employées par rapport à l'algorithme de la figue 1, où toutes les opérations ou presque doivent être répétées à chaque réalisation du bruit.

Conformément à l'invention, le calcul de la matrice de bruit de grenaille $\delta_n$ se décompose en trois parties : le calcul d'une mappe $\sigma_d$ dont chaque élément $\sigma_{d_{i_0,j_0}}$ représente l'écart type de la dose normalisée déposée dans le pixel de coordonnées $(i_0,j_0)$ ; le calcul d'une mappe d'erreur normalisé dite « mère » **E** présentant une longueur de corrélation donnée par la fonction d'étalement du point **PSF** ; et le calcul de $\delta_n$ à partir de $\sigma_d$ et de **E**.

Selon une caractéristique particulièrement avantageuse de l'invention, la mappe $\sigma_d$ est calculée de manière déterministe, à partir du motif **M**$_0$ et de la fonction d'étalement du point **PSF** : par conséquent ce calcul ne doit être effectué qu'une seule fois, et la mappe d'écart type constitue donc un résultat intermédiaire pouvant être stocké en mémoire.

Selon une autre caractéristique particulièrement avantageuse de l'invention, la mappe « mère » **E** est également un résultat intermédiaire, calculé une seule fois à partir d'une matrice $\varepsilon$ de variables aléatoires indépendantes et de la fonction d'étalement du point **PSF.**

Par conséquent, seulement le calcul de $\delta_n$ à partir de **E** et de $\sigma_d$ et la somme **D**$_0$+$\delta_n$, permettant de trouver **D**$_n$ (partie de l'ordinogramme désignée par « R ») doivent être répétés plusieurs fois. Mais, comme cela sera montré plus loin, ces opérations sont très simples.

Mais, dans la plupart des cas, il n'est même pas nécessaire de calculer la mappe de dose **D**$_n$ pour une pluralité de réalisation du bruit de grenaille. Si le but recherché est uniquement de déterminer une plage de positionnement « vraisemblable » des bords d'une structure réalisée par lithographie électronique, il peut être suffisant de considérer deux cas extrêmes : celui où chaque pixel du motif reçoit une dose sensiblement plus élevée que la valeur moyenne attendu, et celui où chaque pixel du motif reçoit une dose sensiblement plus faible que ladite valeur moyenne. Ces cas extrêmes sont obtenus en ajoutant et en retranchant de la mappe de dose déterministe **D**$_0$ la matrice k$\sigma_d$, avec k>0. On comprend que plus k est élevé, plus le risque d'obtenir un bord à l'extérieur de la plage calculée sera faible, mais plus ladite plage sera large ; une valeur de k trop élevé conduirait donc à une estimation excessivement pessimiste de la dimension critique du procédé. En pratique, on prendra généralement k=3. Ce deuxième mode de réalisation, simplifié, de la méthode est illustré en trait pointillé sur l'ordinogramme de la figure 2.

Sur la figure 2, comme d'ailleurs sur la figure 1, les opérations de convolution sont réalisées dans le domaine de Fourier. Il s'agit là d'une caractéristique avantageuse, mais pas essentielle, de la méthode.

Après cette illustration générale de la méthode, on considérera ci-après le calcul de $\sigma_d$ et son utilisation pour déterminer $\delta_n$. Les autres opérations mises en oeuvre par la méthode sont simples (convolutions, sommes) et n'appellent pas de développements particuliers.

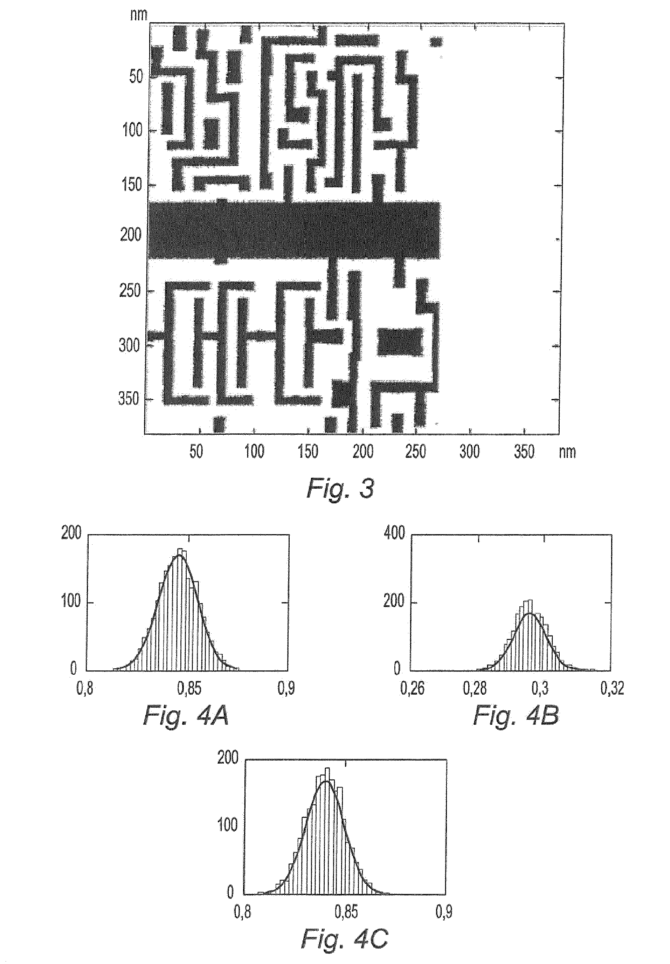

Le calcul de la mappe d'écart type $\sigma_d$ sera d'abord exposé en se rapportant au cas d'un motif tel que celui illustré sur la figure 3, où la dose nominale que l'on souhaite déposer sur chaque pixel vaut soit 0 (pixels blancs) soit N, entier positif (pixels noirs). La dose réellement déposée sur l'échantillon lors de l' « écriture » de chaque pixel est en fait exprimée par une variable aléatoire $m_{i,j}$ présentant une distribution de probabilité suivant la loi de Poisson et dont la valeur moyenne$\langle m_{i,j}\rangle$=$m_{0i,j}$ vaut soit 0 soit N. En outre, les $m_{i,j}$ électrons dirigés sur l'échantillon lors de l'écriture du pixel de coordonnées (i,j) se repartiront en réalité sur une pluralité de pixels en raison de la largeur finie de la fonction d'étalement du point PSF. La dose normalisée **D** est définie par la convolution de **M** et de **PSF**, divisée par N :

$$\mathbf{D} = \frac{1}{N}\mathbf{M}\otimes\mathbf{PSF} = \frac{1}{N}\sum_{i,j} m_{i,j}\,psf_{i-i_0,j-j_0}.$$

Chaque élément $d_{i,j}$ de la matrice D résulte alors de la somme de variables aléatoires indépendantes, dont le nombre est assez grand pour que le théorème de la limite centrale puisse être appliqué. En conséquence, chaque élément de D suit une statistique gaussienne dont l'écart type $\sigma$ est égal à la racine carrée de la somme quadratique des écarts types de tous les pixels du motif. En réalité, il convient de noter que, à strictement parler, la fonction de densité de probabilité ne peut pas être rigoureusement gaussienne, car des valeurs négatives de la dose normalisée sont interdites. Toutefois, si l'écart type est suffisamment petit par rapport à la valeur moyenne, cela peut être négligé.

En effectuant le calcul on obtient :

$$\sigma_{d_{i_0,j_0}} = \sqrt{\sum_{i,j}\left(\sigma_{\frac{m_{i,j}psf_{i-i_0,j-j_0}}{N}}\right)^2} = \sqrt{\sum_{i,j}\frac{psf_{i-i_0,j-j_0}^2}{\langle m_{i,j}\rangle}\left(\langle m_{i,j}\rangle > 0\right)} \qquad (1)$$

Comme l'écart type de la variable aléatoire $m_{i,j}$, $\sigma_{m_{i,j}} = \sqrt{N}$ et $\frac{\langle m_{i,j}\rangle}{N}$=0 ou 1, l'équation ci-dessus peut se simplifier de la façon suivante :

$$\sigma_{d_{i_0,j_0}} = \frac{1}{N}\sqrt{\sum_{i,j} psf^2_{i-i_0,j-j_0}\langle m_{i,j}\rangle} \Rightarrow \sigma_d = \frac{1}{N}\sqrt{\mathbf{PSF}^2\otimes\mathbf{M_0}} \qquad (2)$$

En conclusion, dans le cas où $m_{0i,j}$ vaut soit 0 soit N (cas considéré sur l'ordinogramme de la figure 2, mais uniquement à titre d'exemple non limitatif) la mappe d'écart type $\sigma_d$ est obtenue en calculant la convolution de la mappe de dose nominale $\mathbf{M}_0$ avec la fonction $\mathbf{PSF}^2$, puis en prenant la racine carrée du résultat.

La validité de l'équation 2 a été testée en simulant 2048 fois le motif de la figure 3 avec une PSF donnée par

$$PSF(r) = \frac{1}{\pi(1+\eta)}\left(\frac{1}{\alpha^2}e^{-\frac{r^2}{\alpha^2}} + \frac{\eta}{\beta^2}e^{-\frac{r^2}{\beta^2}}\right)$$

où r est la distance radiale par rapport au centre du faisceau, $\alpha$=25,2 ; $\beta$=297 ; $\eta$=0,48 et avec une dose nominale de 30 $\mu$C/cm$^2$.

Les figures 4A, 4B et 4C montrent les histogrammes de la dose effectivement reçue au niveau de trois pixels de coordonnées (179,130), (188, 271) et (188, 175) ; l'histogramme de la figure 4A est celui qui présente le coefficient d'asymétrie (« *skeweness* ») le plus élevé (c'est à dire que son histogramme de dose présente la plus grande asymétrie du côté des hautes doses), celui de la figure 4B est celui qui présente le coefficient d'asymétrie le plus faible (c'est à dire que son histogramme de dose présente la plus grande asymétrie du côté des faibles doses), et celui de la figure 4C présente un coefficient d'asymétrie nul (c'est à dire que son histogramme de dose est symétrique). Une ligne montre la meilleure interpolation gaussienne. Ces figures permettent de vérifier qu'en effet la dose normalisée $d_{i,j}$ suit une loi de distribution sensiblement gaussienne, ce qui est précisément l'hypothèse à la base de la dérivation des équations 1 et 2.

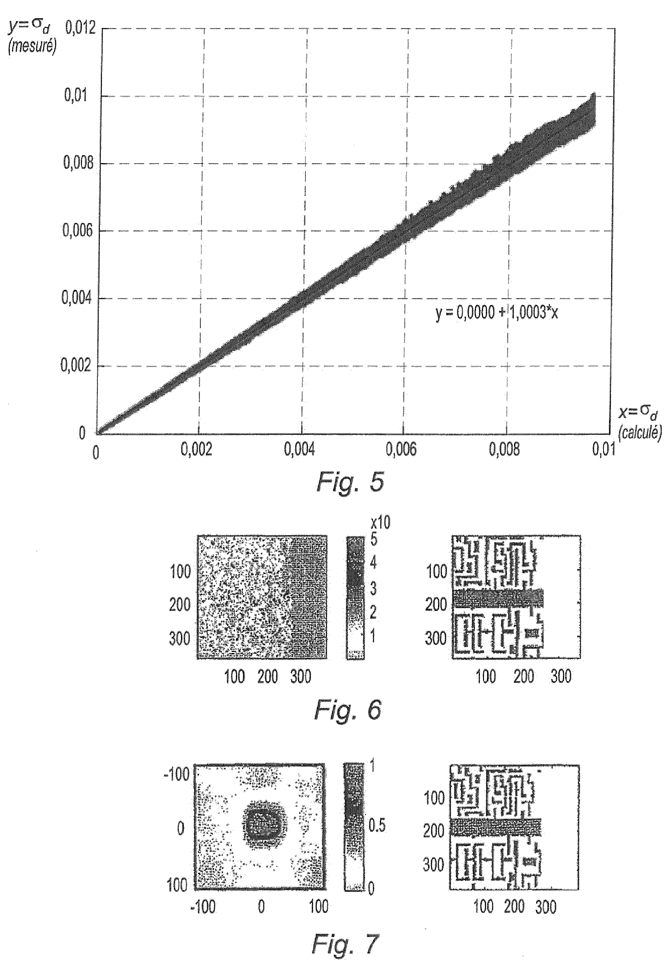

La figure 5 met en relation l'écart type de la dose normalisée mesurée à partir des 2048 simulations (axe vertical « y ») et l'écart type calculé à l'aide de l'équation 1 (axe horizontal « x »). On observe une relation linéaire avec une pente très proche de 1 et aucun décalage.

La partie gauche de la figure 6 est une représentation en échelle de gris de la différence entre la mappe d'écart type mesurée et calculée, permettant de vérifier qualitativement que cet écart ne dépend pas des caractéristiques du motif de lithographie (reproduit, pour mémoire, sur la partie droite de la figure).

Comme expliquée plus haut, la mappe d'écart type $\sigma_d$ calculée à l'aide de l'équation 1 ou 2 permet de déterminer une plage de positionnement des bords d'une structure réalisée par lithographie électronique. En outre, la connaissance de $\sigma_d$ permet le calcul de la mappe de bruit de grenaille $\delta_n$. En effet, conformément à un aspect avantageux de l'invention, ladite mappe $\delta_n$ est obtenue multipliant élément par élément $\sigma_d$ et une mappe d'erreur $\mathbf{E}_n$, représentée par une matrice de variables aléatoires corrélées, de distribution gaussienne et écart type égal à 1 :

$$\delta_n = \mathbf{E}_n \cdot\times \sigma_d \qquad (3)$$

où « $\cdot\times$ » est l'opérateur de multiplication élément par élément.

Il existe plusieurs méthodes pour calculer une matrice de variables aléatoires ayant les propriétés d'auto-corrélation requises ; par exemple on pourrait, de façon conventionnelle, effectuer une décomposition de Cholesky de la matrice de corrélation caractéristique du procédé et en déduire les variables aléatoires corrélées. Selon un aspect avantageux de l'invention, cependant, il est préférable de calculer cette matrice par convolution d'une matrice de variables aléatoires indépendantes et identiquement distribuées, indiquée par $\varepsilon$, et de la fonction d'étalement du point, $\mathbf{PSF}$. De manière encore plus avantageuse, ce calcul peut être effectué une seule fois, pour donner une matrice dite « mère », $\mathbf{E}$. Les différentes matrices $\mathbf{E}_n$ peuvent être obtenues par permutation circulaire des lignes et des colonnes de ladite matrice « mère ». En conclusion, en explicitant le calcul de la convolution dans le domaine de Fourier, on peut écrire :

$$\mathbf{E} = \frac{TF^{-1}[TF(\varepsilon)\cdot TF(\mathbf{PSF})]}{\sqrt{\sum_{i,j} psf^2_{i,j}}} \qquad (4)$$

$$\delta_n = C_{k,l}(E) \cdot \times \sigma_d \qquad (5)$$

où $C_{k,l}$ est l'opérateur qui permute circulairement les lignes et les colonnes de son argument k et l fois, respectivement. Avantageusement, les k et l sont choisis aléatoirement.

Ainsi, les seules opérations qui doivent être répétées une pluralité de fois pour réaliser une étude statistique du procédé de lithographie sont : la permutation circulaire des lignes et des colonnes de la matrice mère E (préalablement stockée en mémoire) pour déterminer $E_n$ ; la multiplication élément par élément de ladite matrice En et de la mappe d'écart type $\sigma_d$ (elle aussi préalablement stockée en mémoire) pour trouver $\delta_n$, et enfin la somme de $\mathbf{D}_0$ (qui est à son tour un résultat intermédiaire préalablement stocké en mémoire) et de $\delta_n$ pour obtenir $\mathbf{D}_n$ :

$$D_n = D_0 + \delta_n \qquad (6)$$

A titre d'exemple, la partie gauche de la figure 7 montre la fonction d'autocorrélation de la dose normalisée calculée pour le pixel du motif identifié par la croix visible sur la partie droite de la même figure. Ce calcul permet de vérifier que la longueur de corrélation est qualitativement liée à la largeur de la fonction d'étalement du point.

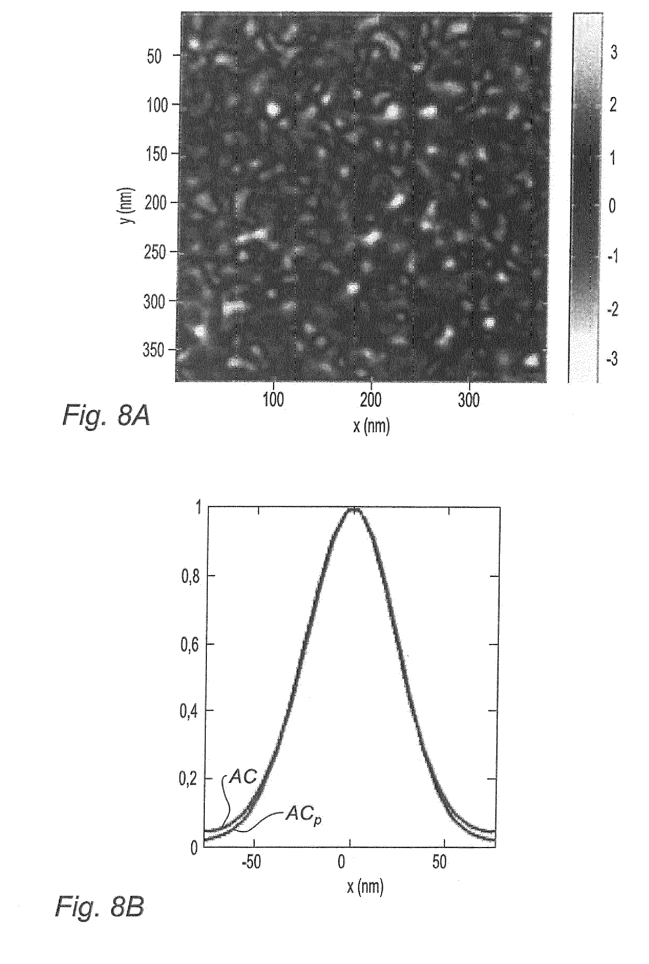

La figure 8A montre une mappe d'erreur obtenue conformément à l'invention (calcul de la mappe mère par application de l'équation 4, puis permutation circulaire des lignes et des colonnes). La figure 8B représente une ligne de la fonction d'autocorrélation AC, qui s'avère être pratiquement identique à celle (ligne $AC_P$) calculée à partir d'un motif aléatoire présentant une distribution de Poisson.

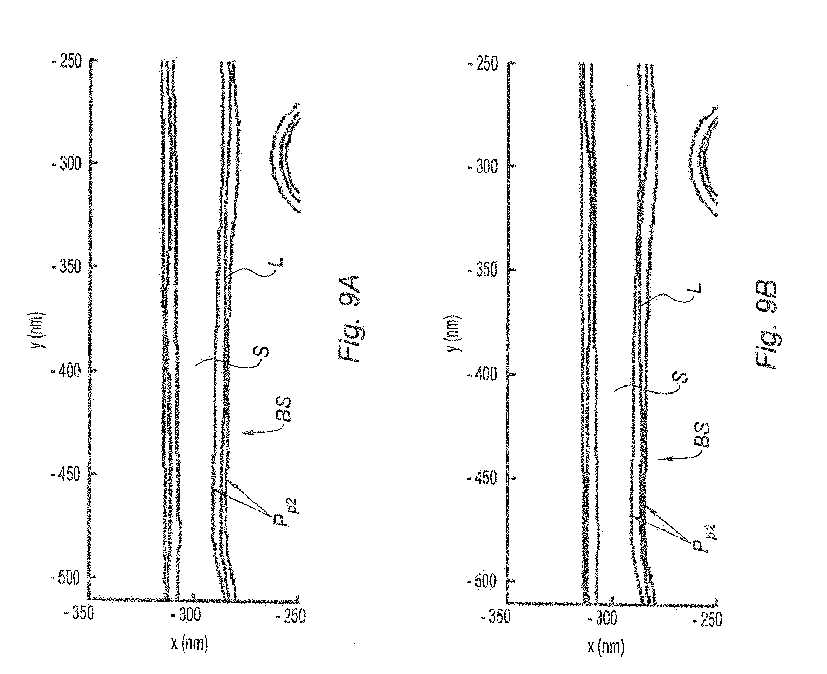

Les figures 9A et 9B permettent de vérifier que, malgré sa remarquable simplicité computationnelle, la méthode de l'invention permet d'obtenir des résultats pratiquement identiques à ceux de la méthode conventionnelle illustrée par l'ordinogramme de la figure 1. Ces deux figures montrent une structure S réalisée par lithographie électronique ; il s'agit plus précisément d'une piste approximativement rectiligne, présentant des bords BS. A cause notamment du bruit de grenaille, il existe une incertitude sur le positionnement de ces bords ; pour cette raison, chaque bord est représenté par deux lignes délimitant une plage de placement $P_{PL}$ ; une ligne L située à l'intérieur de cette plage correspond à un bord obtenu pour une réalisation particulière du procédé. Dans le cas de la figure 9A, la plage de placement $P_{PL}$ est définie en comparant les mappes $\mathbf{D}_0 + 3\sigma_d$ et $\mathbf{D}_0 - 3\sigma_d$ à la valeur seuil de la dose pour la résine de lithographie utilisée par le procédé, $\sigma_d$ étant donnée par l'équation 2, tandis que la ligne L est obtenue par seuillage à partir d'une mappe de dose $\mathbf{D}_n$ générée par application de l'équation 6. La figure 9B, par contre, a été obtenue par une simulation Monte-Carlo complète, conformément à l'art antérieur. La similitude entre les deux figures est remarquable, alors que le gain de temps permis par l'invention par rapport à la simulation Monte-Carlo conventionnelle est de l'ordre d'un facteur 5000.

Si le but recherché est de faire une étude statistique précise des phénomènes en jeu, on calculera la mappe de dose $\mathbf{D}_n$ pour une pluralité de réalisation différentes du bruit de grenaille, et on utilisera chaque mappe $D_n$ ainsi calculée comme variable d'entrée d'un modèle physico-chimique complexe de sensibilité de la résine.

**Revendications**

1. Méthode de simulation des effets du bruit de grenaille sur un procédé de lithographie par faisceau de particules, le procédé comportant le dépôt de particules sur la surface d'un échantillon suivant un motif prédéterminé au moyen d'un faisceau desdites particules, ledit motif étant subdivisé en pixels et une dose nominale de particules étant associée à chaque dit pixel, **caractérisée en ce qu'**elle comprend le calcul d'une mappe $\sigma_d$ d'écart type de la dose normalisée effectivement déposée sur chaque dit pixel, ladite mappe d'écart type étant calculée à partir d'une mappe $\mathbf{M}_0$ de ladite dose nominale associée à chaque pixel et d'une fonction d'étalement du point **PSF** caractérisant ledit procédé ; ladite méthode étant mise en oeuvre par ordinateur.

2. Méthode selon la revendication 1, dans lequel ladite mappe $\sigma_d$ d'écart type est calculée en appliquant la formule suivante :

$$\sigma_{d_{i_0,j_0}} = \sqrt{\sum_{i,j} \frac{psf_{i-i_0,j-j_0}^2}{\langle m_{i,j} \rangle}} \quad (\langle m_{i,j} \rangle > 0)$$

où $\sigma_{d_{i_0,j_0}}$ est l'élément de ladite mappe $\sigma_d$ correspondant au pixel de coordonnées ($i_0$,$j_0$), $psf_{i,j}$ est la valeur de la fonction d'étalement du point **PSF** sur le pixel de coordonnées ($i$,$j$) et$\langle m_{i,j}\rangle$ est l'élément associé au pixel de coordonnées ($_{i,j}$) de ladite mappe $\mathbf{M}_0$ de la dose nominale exprimée en nombre de particules déposées, la somme étant effectuée sur tous les pixels pour lesquels$\langle m_{i,j}\rangle$>0.

3. Méthode selon la revendication 2 dans lequel la dose nominale$\langle m_{i,j}\rangle$ associée à chaque pixel de coordonnées ($_{i,j}$) prend une valeur choisie uniquement parmi 0 et un entier positif N, et dans lequel ladite mappe $\sigma_d$ d'écart type est calculée en appliquant la formule suivante :

$$\sigma_{d_{i_0,j_0}} = \frac{1}{N}\sqrt{\sum_{i,j} psf^2_{i-i_0,j-j_0}\langle m_{i,j}\rangle}$$

4. Méthode selon l'une des revendications précédentes, comportant également une étape de détermination d'une plage de positionnement des bords d'au moins une structure réalisée sur ledit échantillon au moyen dudit procédé de lithographie, ladite étape comprenant :

- le calcul d'une première et d'une deuxième mappe de dose simulée, $\mathbf{D}_1$, $\mathbf{D}_2$ ;
- la comparaison de chaque dite mappe à une valeur seuil de dose pour définir au moins un motif de structure sur ledit échantillon ; et
- l'identification des bords de chaque dit motif de structure ;
ladite plage de positionnement étant comprise entre les bords ainsi identifiés ;
lesdites mappes de dose simulée étant calculées respectivement en ajoutant et en retranchant k$\sigma_d$, avec k>0, à une mappe de dose déterministe $\mathbf{D}_0$ obtenue par convolution de ladite mappe $\mathbf{M}_0$ de dose nominale associée et de ladite fonction d'étalement du point **PSF.**

5. Méthode de la revendication 4, dans laquelle k=3.

6. Méthode selon l'une des revendications précédentes comprenant également une étape de calcul d'une mappe de dose simulée **D** par addition d'une mappe de bruit de grenaille $\delta_n$ à une mappe de dose déterministe $\mathbf{D}_0$, dans laquelle :

- ladite mappe de dose déterministe $\mathbf{D}_0$ est obtenue par convolution de ladite mappe $\mathbf{M}_0$ de dose nominale et de ladite fonction d'étalement du point **PSF** ; et
- ladite mappe de bruit de grenaille $\delta_n$ est obtenue en multipliant élément par élément ladite mappe $\sigma_d$ d'écart type et une mappe d'erreur normalisé $\mathbf{E}_n$ présentant une longueur de corrélation donnée par ladite fonction d'étalement du point **PSF.**

7. Méthode selon la revendication 6, dans lequel ladite mappe d'erreur normalisée est calculée par convolution de ladite fonction d'étalement du point avec une matrice $\varepsilon$ dont les éléments, associés à des pixels respectifs du motif, sont des variables aléatoires gaussiennes indépendantes d'écart type unitaire, et par normalisation du résultat en le divisant par un facteur $\sum_{i,j} psf^2_{i,j}$.

8. Méthode selon l'une des revendications 6 ou 7 dans lequel ladite étape de calcul d'une mappe de dose simulée est répétée une pluralité de fois en utilisant des mappes d'erreur normalisées $\mathbf{E}_n$ obtenues par permutation circulaire aléatoire des lignes et des colonnes d'une unique mappe d'erreur normalisée, dite mappe d'erreur mère **E.**

9. Méthode selon la revendication 8 dans lequel les mappes d'erreur normalisées $\mathbf{E}_n$ ainsi obtenues sont utilisées comme variables d'entrée d'un modèle physico-chimique de la résine.

10. Méthode selon la revendication 8 comportant également une étape de comparaison de chaque dite mappe de dose simulée à une valeur seuil de dose pour définir au moins un motif de structure respectif sur ledit échantillon

11. Méthode selon la revendication 10 comportant également une étape d'identification des bords de chaque dit motif de structure.

12. Méthode selon l'une des revendications 8, 10 ou 11 comportant :

    a) le calcul et le stockage dans une mémoire d'ordinateur de ladite mappe de dose déterministe $D_0$, de ladite mappe $\sigma_d$ de écart type de la dose normalisée et de ladite mappe d'erreur mère **E** ;
    b) le calcul de ladite mappe de bruit de grenaille $\delta_n$ par permutation circulaire des lignes et des colonnes de ladite mappe d'erreur mère **E** et sa convolution avec ladite mappe $\sigma_d$ d'écart type de la dose normalisée ;
    c) le calcul d'une mappe de dose simulée **D** par addition de ladite mappe de dose déterministe $D_0$ et de ladite mappe de bruit de grenaille $\delta_n$ ;
    lesdites étapes b) et c) étant répétées une pluralité de fois avec des permutations circulaires différentes de lignes et des colonnes de ladite mappe d'erreur mère **E**.

13. Méthode selon l'une des revendications précédentes, dans lequel ledit procédé de lithographie par faisceau de particules est un procédé de lithographie électronique.

14. Méthode selon l'une des revendications précédentes dans lequel ledit procédé de lithographie utilise un adressage vectoriel du faisceau, la méthode comportant également une opération de subdivision conceptuelle dudit motif en pixels et de détermination d'une dose reçue par chaque dit pixel.

15. Produit programme d'ordinateur pour la mise en oeuvre d'une méthode selon l'une des revendications précédentes.

16. Ordinateur programmé pour la mise en oeuvre d'une méthode selon l'une des revendications 1 à 14.

17. Procédé de lithographie par faisceau de particule comportant une opération préalable de simulation des effets du bruit de grenaille par une méthode selon l'une des revendications 1 à 14.

Fig. 1

Fig. 2

Fig. 3

Fig. 4A

Fig. 4B

Fig. 4C

*Fig. 5*

*Fig. 6*

*Fig. 7*

*Fig. 8A*

*Fig. 8B*

Fig. 9A

Fig. 9B